Europäisches Patentamt

European Patent Office

Office européen des brevets

(11) Publication number: **0 134 692**
**A2**

# EUROPEAN PATENT APPLICATION

(21) Application number: **84305165.7**

(22) Date of filing: **30.07.84**

(51) Int. Cl.⁴: **H 01 L 23/48**
**H 01 L 21/285, H 01 L 23/52**

(30) Priority: **19.08.83 JP 150149/83**

(43) Date of publication of application:
**20.03.85 Bulletin 85/12**

(84) Designated Contracting States:
**DE FR GB NL**

(71) Applicant: **HITACHI, LTD.**
6, Kanda Surugadai 4-chome Chiyoda-ku
Tokyo 100(JP)

(72) Inventor: **Warabisako, Terunori**
2196-143, Hirai Hinodemachi
Nishitama-Gun Tokyo(JP)

(72) Inventor: **Ohkura, Makoto**
2-32-V407, Koyasu-Cho
Hachioji-Shi Tokyo(JP)

(72) Inventor: **Miyao, Masanobu**
1188-5-107, Kamiarai
Tokorozawa-Shi Saitama-Ken(JP)

(74) Representative: **Calderbank, Thomas Roger et al,**
MEWBURN ELLIS & CO. 2/3 Cursitor Street
London EC4A 1BQ(GB)

(54) Multilayer semiconductor devices with embedded conductor structure.

(57) A semiconductor substrate (1) has an insultion layer (2, 9) on its surface with a semiconductor layer (6) on the insulation layer (2, 9). The semiconductor layer (6) contacts the substrate (1) through a hole (3) in the insulation layer (2, 9). A conductive region containing a conductive layer 10 of semiconductor material is provided in the insulation layer (2, 9). The conductive layer is separated by insulation (11) from the semiconductor layer (6) and by insulation (9) from the substrate (1). The surface of the insulation (11) is substantially level with the surface of the insulation layer (2) as this prevents the formation of defects in the semiconductor layer (6) adjacent the conductive region, which defects would otherwise reduce the carrier mobility and increase the leakage current. The device may include additional semiconductor and insulator layers, with additional conductive regions, so that a stacked structure may be formed.

*FIG. 2*

The present invention relates to a semiconductor device in which a semiconductor layer is formed on a semiconductor substrate with an insulator between them.

A semiconductor device having a Silicon on Insulator (SOI) structure, in which a single-crystalline or virtually single-crystalline semiconductor thin film is formed on a semiconductor substrate with an insulator between them, has advantages over a semiconductor device which is fabricated using only a semiconductor substrate.  In particular, it is easy to achieve electrical isolation with the semiconductor thin film, and the arrangement of p-type and n-type regions is relatively un-restricted, so that a semiconductor device of complementary circuitry having an excellent electrical performance may be fabricated.  In addition, operation at a higher frequency may be achieved due to the fact that parasitic capacitances are small.  In addition, the semiconductor device may be combined vertically with elements formed on the surface of the substrate and may be integrated with a higher packing density.

Examples of a device having a SOI structure are disclosed in e.g. US-A-3,484,662 and US-A-3,393,088.

The advantages of such a structure may be increased by providing a conductive layer over the device. The conductive layer may be used as the gate of a field effect transistor (FET) formed on the surface of the semiconductor substrate or an FET disposed under the semiconductor thin film, and the layer may also act as the interconnection between devices.

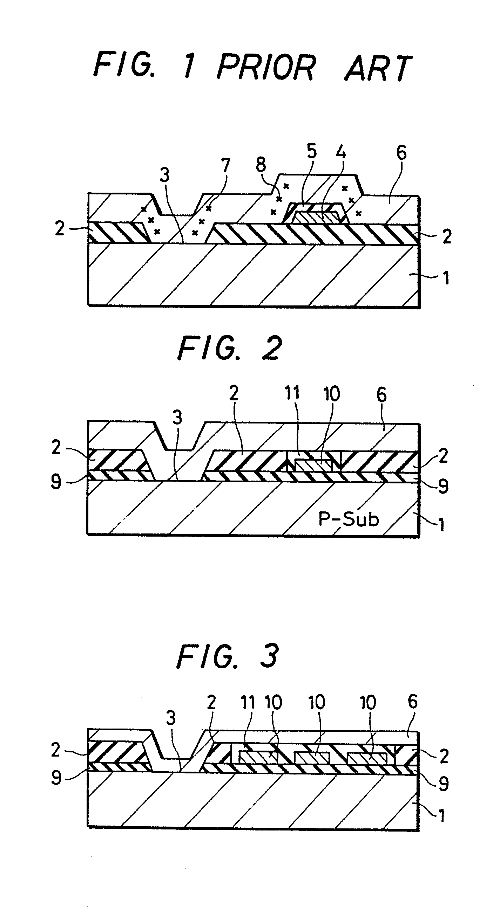

Fig. 1 of the accompanying drawings is a cross-sectional view showing a prior-art semiconductor device having a SOI structure. In the figure, a single-crystalline silicon substrate 1 has a (100) orientation and regions (not shown) are formed in suitable patterns on the surface of the substrate 1, the conductivity types and resistivities of the regions being controlled. A main insulator 2 is provided on the substrate 1, an opening 3 is provided in the main insulator 2, and a conductive layer 4 is formed on the main insulator 2, the conductive layer 4 having a suitable interconnection pattern. An insulator 5 covers the conductive layer 4, and a single-crystalline silicon (Si) film 6 is formed on the main insulator 2. In order to form this Si film 6, a polycrystalline silicon layer is deposited on the main insulator 2 and is thereafter recrystallized by, e.g. scanning with a laser beam. When this is done the temperature of the polycrystalline Si layer becomes equal to or higher than

- 3 -                                    0134692

the melting point thereof (or a temperature close thereto).  In order to ensure that the electrical insulation between the Si film 6 and the conductive layer 4, which is made of a refractory metal or polycrystalline Si, is maintained whilst the Si film 6 is heated, the conductive layer 4 needs to be covered with the insulator 5 which does not react with the conductive layer 4 at this temperature.

In many cases, however, the performance of such a semiconductor device is not good.  The main reason for this is that defects 7 and 8 appear in the parts of the Si film 6 corresponding to the opening 3 and the step of the conductive layer 4 and these defects cause an increase in the leakage current and a decrease in the carrier mobility.

Thus, in an n-channel MOS-FET in which a channel region is formed in the flat part of the Si film 6, a carrier mobility of at least 600 $cm^2/V \cdot s$ may be achieved in the flat part, whereas the carrier mobility in the step part is only about 400 $cm^2/V \cdot s$.  When the part of the Si film 6 corresponding to the opening 3 forms part of a doped region, the defects 7 pose no problem.  In contrast, if the part of the Si film 6 corresponding to the conductive layer 4 is utilized for an active region, which is often the case, the defects 8 prevent the fabrication of a useful integrated circuit of such construction.

The present invention seeks to overcome, or at least ameliorate, the problems of the prior art, and in particular to reduce the likelihood of defects occurring in the semiconductor layer on the substrate. According to the present invention, this is achieved by making the conductive region, which comprises the conductive layer and insulation between the conductive layer and the substrate and between the conductive layer and the semiconductor layer, substantially level with the surface furthest from the substrate of the insulation layer separating the semiconductor layer and the substrate.

The conductive layer may be provided in a groove in the substrate or the entire conductive region may be of substantially the same thickness as the insulation layer. A part of the insulation layer may then form the insulation between the conductive layer and the substrate. It is convenient if that part is formed by oxidising the surface of the substrate, the rest of the insulation layer then being formed by deposition.

The surface of the conductive region need not be exactly level with the surface of the insulation layer, but the smaller the step between them, the less risk there is of defects occurring. A device with a step of 950mm may occasionally produce good results but it is preferable that the step is less than 100mm if the device free from defects is to have a high reproducibility.

Embodiments of the present invention will now be described, by way of example, with reference to the accompanying drawings, in which:

Fig. 1 is a cross-sectional view showing a prior-art semiconductor device, and has already been discussed;

Fig. 2 is a cross-sectional view showing a semiconductor device being a first embodiment of the present invention;

Fig. 3 is a cross-sectional view showing a semiconductor device being a second embodiment of the present invention;

Fig. 4 is a cross-sectional view showing a semiconductor device being a third embodiment of the present invention;

Fig. 5 is a cross-sectional view showing a semiconductor device being a fourth embodiment of the present invention;

Fig. 6 is a cross-sectional view showing a semiconductor device being a fifth embodiment of the present invention; and,

Figs. 7A and 7B are graphs each showing the relationships between the scanning conditions of a laser and the crystallinity of a single-crystalline

Si film.

Embodiment 1

Fig. 2 is a cross-sectional view showing the first embodiment of a semiconductor device according to the present invention. Referring to that figure, an insulator 9 made of $SiO_2$, is formed on a substrate 1 and a main insulator 2 is formed on the insulator 9. A conductive layer 10 is embedded in the main insulator 2, and an insulator 11 covers the conductive layer 10. The heights of the main insulator 2 and the covering insulator 11 are substantially equal.

In order to manufacture this semiconductor device, the surface of a p-type single-crystalline silicon substrate 1 having the (100) face must first be thermally oxidized, thereby to deposit the insulator 9 to a thickness of approximately 100mm. Subsequently, polycrystalline silicon is deposited to a thickness of 3000 $\overset{o}{A}$ by e.g. low-pressure chemical vapour deposition and implanted with $^{31}P^+$ ions at a concentration of $5 \times 10^{15} cm^{-2}$, and then the resultant substrate is annealed. Next, the substrate is spin-coated with a negative type photoresist, which is exposed to light. Then, the conductive layer (polycrystalline Si) is etched, thereby to form a conductive layer 10 which is 3μm wide. In the next step, $SiO_2$ with a thickness of 350mm Å is deposited by e.g. plasma CVD, with the photoresist on the conductive layer 10 being left intact, and the $SiO_2$ and photoresist on the conductive layer 10 are then removed by e.g. a lift-off method, so that the insulator 2 has a suitable pattern.

Thus, the photoresist used for the etching of the conductive layer 10 remains on the layer 10 until the deposition of $SiO_2$, and after the $SiO_2$ is deposited on the photoresist, it is removed simultaneously with the removal of the photoresist.

It is therefore possible to remove only the $SiO_2$ in the area conforming in shape to the conductive layer 10.

The substrate is thereafter annealed in a dry oxygen atmosphere, so that the conductive layer 10 becomes covered with an insulator 11 made of $SiO_2$ having a thickness of 50mm. Thus, the surface of the conductive layer 10 has a thermal oxide layer formed thereon by annealing.

It is desirable that there is no gap between the conductive layer 10 and the main insulator 2. In practice, however, the conductive layer 10 is smaller than the photoresist. This is due to e.g. overetching.

Even with the lift-off method, therefore, a gap may be formed between the conductive layer 10 and the main insulator 2.  This gap may be filled by the thermal oxidation because the oxide $SiO_2$ has a volume about double that of the original Si.

In this way, the V-shaped gap formed at the boundary between the conductive layer 10 and the main insulator 2 may be removed, and simultaneously the density of the insulator 2 may be increased. When this is done, there is virtually no step between the upper edge of the insulator 11 and that of the main insulator 2, and the height of any protruberant part of the insulator 11 at the boundary between the insulator 2 and the conductive layer 10 is desirably less than 20mm.  Next, an opening 3 having a diameter of e.g. 30μm is provided in the oxide layers 2, 9 by a conventional photoresist process, and then a polycrystalline silicon layer having a thickness of e.g. 40mm is deposited by the low-pressure CVD.  Subsequently, using a cw laser of argon (Ar) having a power output of e.g. 7 W, the polycrystalline Si layer is irradiated with a beam having a spot diameter of about 50μm, with the beam being scanned at a velocity of 20cm/sec.  Thus, the polycrystalline Si layer is recrystallized ·by employing as a seed the part of the substrate 1 corresponding to the opening 3, and a single-crystalline silicon film 6 is formed.

Diodes were formed in such a device, each

- 9 -                                    0134692

of which included in its junction area the part of the
Si film 6 corresponding to the opening 3 in such semiconductor device, and reverse currents of $10^{-8}$ to
$10^{-7}$ A/cm$^2$ were exhibited with reverse biases of 1 V.
In contrast, when diodes were formed with the junction
area of each being in the Si film 6 on the conductor
layer 10, an average improvement of substantially
one order of magnitude was observed.

Embodiment 2

Fig. 3 is a cross-sectional view showing
another embodiment of the present invention.  In the
figure, the use of the numerals of Fig. 2 indicates
that the corresponding parts are identical or
equivalent.  The second embodiment differs from the
first in that a plurality of conductive layers 10
are formed.

If a plurality of adjacent conductive layers
4 are formed in the prior-art semiconductor device
shown in Fig. 1, the number of steps in the Si film
6 is double the number of conductive layers 4.
Therefore, because of the characteristics of the
resultant device, it is impracticable to form a
plurality of adjacent conductive layers 4.  With a
device according to the present invention, there
need be no step even when the plurality of adjacent
conductive layers 10 are formed as illustrated in
Fig. 3.

Therefore, there is no disadvantage in providing a large number of adjacent conductive layers 10.

Embodiment 3

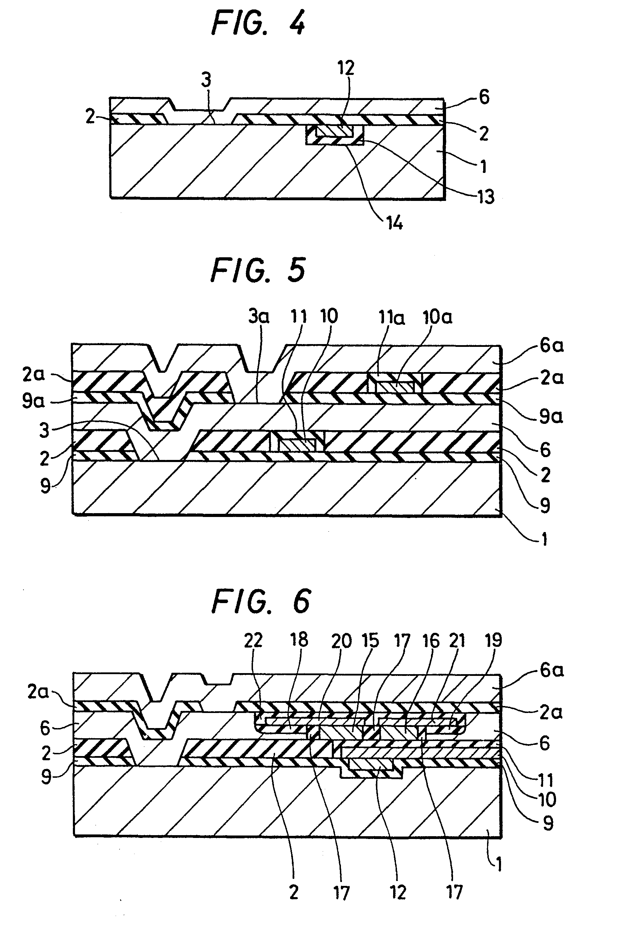

Fig. 4 is a cross-sectional view showing another semiconductor device according to the present invention. In the figure, a conductive layer 12 is embedded in a groove 14 in a substrate 1, and an insulator 13 separates conductive layer 12 from the walls of the groove.

Also shown are an insulator 2, an opening 3 and a single-crystallized Si film 6.

In this embodiment the thickness of the insulator 2 may be made smaller than that of the conductive layer 12.

In manufacturing this semiconductor device, first the groove 14 is formed in the substrate 1 by a conventional dry etching method. Subsequently, an insulator is formed by e.g. plasma CVD, and then a polycrystalline Si layer is formed by e.g. low-pressure CVD. Next, the polycrystalline Si layer and the insulator, except their parts corresponding to the groove 14, are removed by sputter etching, to form the conductive layer 12 and the insulator 13 respectively. When this is done, there is virtually no step between the upper edge of the conductive layer 12 and that of the substrate 1.

After the insulator 2 is formed, the opening 3 is formed in it.  Subsequently, a polycrystalline Si layer is deposited and is recrystallized by a conventional laser annealing method, to form the Si film 6.

Embodiment 4

Fig. 5 is a cross-sectional view illustrative of another semiconductor device according to this invention.  In the figure, the use of the numerals of Fig. 2 indicate that the corresponding parts are identical or equivalent.  An insulator 9a is provided on the Si film 6, a main insulator 2a is provided on the insulator 9a, and an opening 3a is formed in the insulators 2a and 9a.  A conductive layer 10a is embedded in the insulator 2a, an insulator 11a covers the conductive layer 10a, and a single-crystalline Si film 6a is formed on the insulator 2a.  The thickness of the insulator 2 or 2a is such that crosstalk between the substrate 1 and the  Si film 6 or between the Si films 6 and 6a may be prevented.

Elements of the device may be formed in the respective single-crystalline Si films, and an integrated circuit of high packing density and a stacked structure may thus be formed.  The conductive layers 10 and 10a are used for transmitting signals.  Thus, for example, the conductive layer 10 may act as the gate of a MOS transistor formed on the substrate 1 and as the gate of a MOS transistor formed on the semiconductor layer 6. In this case, a gate insulator may be formed by adjusting the thickness of the insulator 9 or the insulator 11. Similarly, the conductive layer 10a may be used as the gate of a MOS transistor formed on the semiconductor layer 6 or 6a.

The semiconductor layer 6 or 6a may also be turned into a conductor by, for example, heavily doping it with an impurity or forming it from a metal silicide. Then, it may be used as an interconnection member.

Thus, with such a device the respective semiconductor layers may be connected through the openings 3, 3a etc. and it is easy to achieve suitable electrical connection.

In this manner, a device design of high versatility is permitted by stacking the semiconductor layers.

In order to exploit fully the advantages of such structure, it is desirable that each semiconductor layer has a good crystallinity. It will be readily understood that the flat structure of a device according to the present invention helps to achieve this.

Embodiment 5

Fig. 6 is a cross-sectional view showing another semiconductor device according to the present invention. In the figure, conductive layers 15 and 16 are embedded in a Si film 6. The longitudinal direction of each of the conductive layers 15 and 16 is perpendicular to the plane of the drawing, and the thickness thereof is not greater than half the thickness of the Si film 6. An insulator 17 covers the side parts of the conductive layers 15 and 16. Heavily doped regions 18 and 19 are formed in the Si film 6, and are connected to other elements (not shown) formed in the Si film 6. The connection to other elements is necessary e.g. where one or both of the doped regions 18 or 19 are used as the source, drain or gate of a MOS transistor or where they are used as the base, emitter or collector of a bipolar transistor.

Conductive layers 20 and 21 are embedded in the Si film 6. The longitudinal direction of each of the conductive layers 20 and 21 is parallel to the plane of the drawing, and their thickness is not greater than half of the thickness of the Si film 6. The conductive layers 20, 21 serve to connect the conductive layers 15, 16 and the diffused regions 18, 19. An insulator 22 covers the conductive layers 20 and 21. The sum of the thicknesses of the conductive layer 15 or 16, the conductive layer 20 or 21 and the insulator 22 is substantially equal to the thickness of the Si film 6. A conductive layer 12 is connected with elements (not shown) formed on the surface of a substrate 1, and the conductive layer 12 and a conductive layer 10 which extends orthogonally thereto are connected.

Thus, many of the interconnections for connecting the elements formed on the Si film 6 can be formed within the thickness of the Si film 6.

In forming the conductive layers 15, 16, etc. of this semiconductor device, the conductive layers 15, 16 and the insulator 17 are first formed to thicknesses substantially equal to the thickness of the Si film 6, and then the parts of the Si film 6 to form the diffused regions 18, 19 therein and the conductive layers 15, 16 and the insulator 17 are etched simultaneously. Next, the diffused regions 18, 19 are formed, and then the conductive layers 20, 21 and the insulator 22 are formed.

The insulator films 17 may be thermal oxide films formed from the side surfaces of the conductive layers 15, 16 and the Si film 6.

When a material which cannot be subjected to thermal oxidation is employed to form the conductive layers 15, 16, the insulator may be deposited by e.g. CVD.

The above discussion of the embodiments of the present invention has assumed that the semiconductor substrate and the semiconductor thin film are made of Si. However, the present invention is also applicable to a semiconductor device which employs a compound semiconductor such as GaAs. In addition, whilst the description of the embodiments discusses the case where the conductive layer 10 is made of the polycrystalline Si heavily doped with an impurity, a refractory metal such as molybdenum (Mo) or tungsten (W) or an alloy containing such a metal may be used as the material of the conductive layer. Also, the single-crystalline Si film 6 need not be formed by scanning a laser beam to achieve recrystallization, but instead the recrystallizing operation may be performed by scanning an energetic beam such as an electron beam or by employing a strip heater. The recrystallization step may use polycrystalline Si, as described above, or amorphous Si may be crystallized.

The Si film 6 may be formed using the substrate 1 as the seed, or may be formed by single-crystallization employing no seed crystal. In this latter case, it is more advantageous to single-crystallize amorphous Si.

In the above embodiments, the upper edge of the insulator 11 or 22 was made level with that of the insulator 2 or Si film 6, but the upper edge of the conductive layer 10 or the conductive layer 20 or 21 may be made level with that of the insulator 2 or Si film 6. Then, the step between the upper edge of the insulator 2 or Si film 6 and that of the conductive layer portion may be achieved within the thickness of the insulator 11 or 22, and it is advantageous to set the height of the step at or below 1000 $\overset{\text{O}}{\text{A}}$.

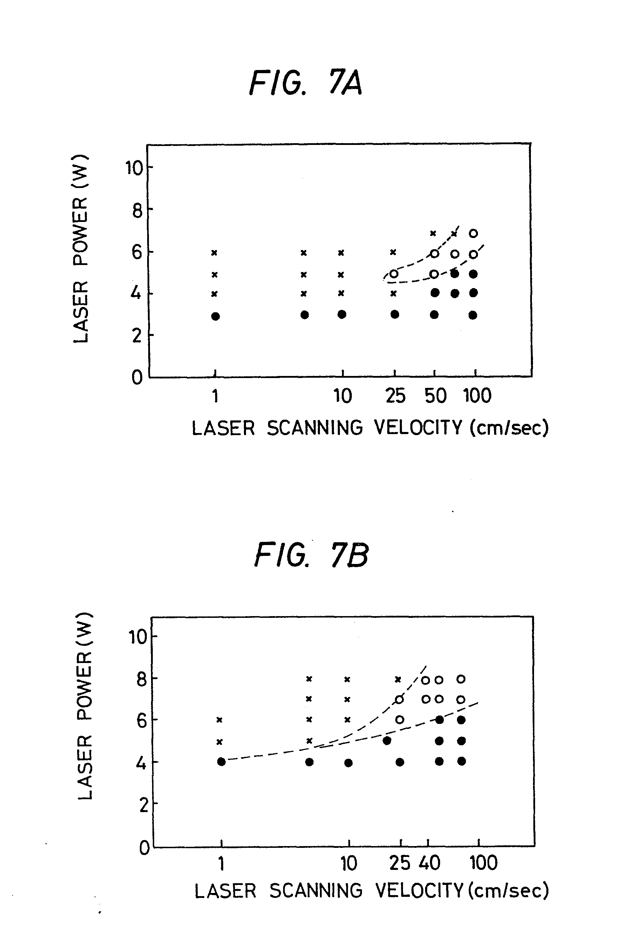

Figs. 7A and 7B are graphs each showing the relationships between the laser scanning velocity, the laser power and the crystallinity of a single-crystalline Si film where polycrystalline Si was recrystallized so that polycrystalline Si with a thickness of 3500 $\overset{\text{O}}{\text{A}}$ was deposited on a structure having an oxide step and then scanned by a cw laser of Ar. Figs. 7A and 7B correspond to the cases where the oxide steps were 9500 $\overset{\text{O}}{\text{A}}$ and 3500 $\overset{\text{O}}{\text{A}}$, respectively. Marks X, O, and ● respectively indicate that the single-crystalline Si film was broken, that the regrowth of the single-crystalline Si film was favourable, and that the polycrystalline Si did not regrow. As is clear from the graphs, when the oxide step has a thickness of 950mm, a good crystal may sometimes be obtained even at a laser scanning velocity as low as 25cm/sec, but the reproducibility is almost nill. In order to attain a favourable crystallinity, the recrystallization needs to be performed under narrowly limited conditions, with the laser scanning velocity at least 50cm/sec and that the laser power approximately 6 W. Moreover, it cannot be said that the reproducibility is high. In contrast, when the oxide step has a thickness of 350mm, the regrowth of good crystals is possible under a comparatively wide range of conditions with the laser scanning velocity at least 40cm/sec and the laser power between 6 and 8 W. The allowable width of the laser power at a laser scanning velocity of 25cm/sec is about 1 W, and the reproducibility is high. The results are based on the fact that, depending upon the thickness of the oxide film, the conduction of heat (particularly in the direction of the substrate) differs to give rise to the differences in the conditions of the recrystallization. As the oxide step becomes smaller, it becomes less influential.

As set forth above, in a semiconductor device according to this invention, steps in the conductive layer portion of a semiconductor thin film may be small, and hence the crystallinity of the semiconductor thin film becomes favourable. This produces the advantage that the electrical performance of the semiconductor thin film is improved. Other advantages are that the risks of the breaking of interconnections, etc. at the steps decrease if multilayer interconnections are formed, so that the yield is enhanced and the reliability

is improved.

CLAIMS

1.   A semiconductor device having a substrate (1), a semiconductor layer (6,6a) a first part (3,3a) of which is in electrical contact with the substrate (1), an insulation (2,2a,9,9a) layer between a second part of the semiconductor layer (6,6a) and the substrate (1), and a conductive region having a conductive layer (10,10a,12,12a,15,16) insulation (2,2a,11,11a,22) between the conductive layer (10, 10a,12,12a,15,16) and the semiconductor layer 16a, and insulation (9,9a,14) between the conductive layer (10,10a,12,12a,15,16) and the substrate; characterised in that :

the surface of the conductive region furthest from the substrate (1) is substantially level with the surface  of the insulation layer (6,6a) furthest from the substrate.

2.   A device according to claim 1, wherein the conductive region is at least partially recessed in a groove (14) in a surface of the substrate (1).

3.   A device according to claim 1 or claim 2, wherein the insulation layer (2,9) directly contacts a part of the surface of the substrate (1).

4.   A device according to any one of the preceding claims, wherein the semiconductor layer is a first semiconductor layer (6) and there is a second semiconductor layer (6a) a part of which is in electrical contact with the first semiconductor layer (6), wherein the insulation layer is a first insulation layer (2,9) and there is a second insulation layer (2a,9a) between a part of the first semiconductor layer (6) and the second semiconductor layer (6a); and wherein the conductive region is a first conductive region, and there is a second conductive region having a conductive layer (10a), insulation (11a) between the conductive layer (10a) and the second semiconductor layer (6a), and insulation (9a) between the conductive layer (10a) and the first semiconductor layer (6), the surface of the second conductive region furthest from the substrate (1) being substantially level with the surface of the second insulation layer (6a) furtherest from the substrate (1).

5. A device according to claim 1 or claim 2, wherein the semiconductor layer is a second semiconductor layer (6a), and there is a first semiconductor layer (6), a first part of which is in electrical contact with a first part of the second semiconductor layer (6a) and a second part of which is in electrical contact with the substrate (1); and wherein the insulation layer is a second insulation layer (2a,9a) between a third part of the first semiconductor layer (6) and a second part of the second semiconductor layer (6), and there is a first insulation layer (2,9,11) between a fourth part of the first semiconductor layer (6) and the substrate (1).

6. A device according to claim 5, wherein the surface of the conductive region nearest the substrate contacts a surface of the first semiconductor layer (6) furthest from the substrate (1).

7. A device according to claim 5, wherein the conductive region extends through the first semiconductor layer (6) such that a part (9,11) of the first insulation layer (2,9,11) forms the insulation between the conductive layer (15,16) and the substrate (1).

8. A device according to claim 7 wherein the conductive region contains at least one impurity region (18,19) contacted by the first semiconductor layer (6), the impurity region(s) being electrically connected to the conductive layer (15,16).

9. A device according to any of the preceding claims, wherein the insulation layer (2,2a,9,9a) comprises a thin insulation layer (9,9a) and a main insulator layer (2,2a) between the thin insulator (9,9a) and the semiconductor layer (6,6a), a part of the thin insulator layer (9,9a) extending between the conductive layer (10,10a) and the substrate, whereby that part forms the insulation (9,9a) between the conductive layer (10,10a) and the substrate (1).

10. A device according to claim 9 as dependant on claim 2, wherein the thin insulation layer (9) is formed by oxidising a part of the substrate (I) and the main insulation layer (6) is formed by deposition.

11. A device according to any one of the preceding claims, wherein the conductive region has a plurality of conductive layers (10 ; 12,15,16) the conductive layers (10,12,15,16) being seperated by insulator films.

12. A device according to any one of the preceding claims wherein the or each conductive layer is of semiconductor material.

1/3

0 1 3 4 6 9 2

## FIG. 1 PRIOR ART

## FIG. 2

## FIG. 3

FIG. 4

FIG. 5

FIG. 6

3/3

0134692

*FIG. 7A*

LASER POWER (W) vs LASER SCANNING VELOCITY (cm/sec)

*FIG. 7B*

LASER POWER (W) vs LASER SCANNING VELOCITY (cm/sec)